# EUROPEAN PATENT APPLICATION

(11) **EP 4 811 974 A1**
(43) Date of publication of application: **23.09.2026**
(21) Application number: 25855704.0
(22) Date of filing: 28.05.2025
(51) Int. Cl.: H10F 77/20

(54) **BACK CONTACT CELL, CELL ASSEMBLY AND PHOTOVOLTAIC SYSTEM**

(30) Priority: 23.08.2024 CN 202422064592 U
(71) Applicant: Zhejiang Aiko Solar Energy Technology Co., Ltd., Yiwu, Jinhua Zhejiang 322000 (CN); Tianjin Aiko Solar Energy Technology Co., Ltd., Tianjin 300400 (CN); Guangdong Aiko Solar Energy Technology Co., Ltd., Foshan, Guangdong 528000 (CN); Shandong Aiko Solar Technology Co., Ltd, Jinan, Shandong 250000 (CN); Zhuhai Fushan Aiko Solar Technology Co., Ltd., Zhuhai, Guangdong 519000 (CN)
(72) Inventor: WANG, Yongqian, Jinhua, Zhejiang 322000 (CN); XU, Zhigang, Jinhua, Zhejiang 322000 (CN); JIANG, Fei, Jinhua, Zhejiang 322000 (CN); YANG, Xinqiang, Jinhua, Zhejiang 322000 (CN); CHEN, Gang, Jinhua, Zhejiang 322000 (CN)
(74) Representative: EP&C
(86) International application number: PCT/CN2025/097804
(87) International publication number: WO 2026/040533

(57) **Abstract**

The present application is applicable to the field of solar cell technology, and provides a back-contact cell, a cell assembly, and a photovoltaic system. **In** the back-contact cell, in a first interconnection region, a first conductive grid line has a first discontinuous structure, and the first discontinuous structure includes a plurality of first grid line segments disposed at intervals along a second direction. The first conductive connector covers the first discontinuous structure and is electrically connected to the first grid line segment. **In** this way, by configuring the first conductive grid line in the first interconnection region as a discontinuous structure and then covering the first discontinuous structure with the first conductive connector to achieve soldering with the soldering members, compared with the conventional method of thickening and widening the fine grid line at the soldering position, this configuration can ensure soldering performance and reduce usage of paste in the preparation of the first conductive grid line, thereby lowering cost.

## Description

### Cross-Reference to Related Application

The present application claims the priority to Chinese Patent Application No. 202422064592.5, filed with the China National Intellectual Property Administration on August 23, 2024 and entitled "Back-Contact Cell, Cell Assembly, and Photovoltaic System", which is incorporated herein by reference in its entirety.

### Technical Field

The present application relates to the field of solar cell technology, and in particular, to a back-contact cell, a cell assembly, and a photovoltaic system.

### Background

In the related art, according to a back-contact solar cell, to achieve stable soldering between a solder ribbon and a fine grid line, a soldering position between the fine grid line and the solder ribbon is usually widened. However, in such a case, a large amount of silver paste is used for the fine grid line, resulting in high cost.

### Summary

The present application provides a back-contact cell, a cell assembly, and a photovoltaic system, which are intended to solve the technical problem in the related art in which high cost is caused by a large amount of silver paste used in a back-contact cell.

The present application is implemented as follows. A back-contact cell in an embodiment of the present application includes:
a silicon substrate, where the silicon substrate is provided with a back side and a front side opposite to each other, and the back side is provided with a plurality of first interconnection regions and a plurality of second interconnection regions for arranging soldering members;
a plurality of first doped layers and a plurality of second doped layers disposed on the back side, where the first doped layer and the second doped layer have opposite polarities, the plurality of first doped layers and the plurality of second doped layers are alternately arranged along a first direction and extend along a second direction, and the second direction intersects the first direction;
a first conductive grid line disposed on the first doped layer and a second conductive grid line disposed on the second doped layer, where the first conductive grid line is electrically connected to the first doped layer, the second conductive grid line is electrically connected to the second doped layer, the first conductive grid line and the second conductive grid line both extend along the second direction, the first interconnection region intersects each of the first conductive grid line and the second conductive grid line, the second interconnection region intersects each of the first conductive grid line and the second conductive grid line, at least a portion of the first conductive grid line in the first interconnection region is provided with a first discontinuous structure, and the first discontinuous structure includes a plurality of first grid line segments disposed at intervals; and
a plurality of first conductive connectors, where the first conductive connector covers the first discontinuous structure and is electrically connected to the first grid line segment, the first conductive connector is insulated from the second conductive grid line, and the first conductive connector is configured to solder with the soldering members arranged in the first interconnection region.

In some embodiments, the first conductive connector is further partially electrically connected to portions of the first conductive grid line located on two sides of the first discontinuous structure.

In some embodiments, the first conductive connector satisfies at least one of the following: a glass content in the first conductive connector is greater than a glass content in the first conductive grid line; or a material of the first conductive connector is different from a material of the first conductive grid line, and a silver content in the first conductive connector is less than a silver content in the first conductive grid line.

In some embodiments, the first conductive connector is partially embedded between two adjacent first grid line segments.

In some embodiments, in the second direction, an overall length of the first discontinuous structure is 0.05 mm to 5 mm.

In some embodiments, a length of a single first grid line segment in the second direction is greater than 0.02 mm.

In some embodiments, in the first discontinuous structure, a spacing between two adjacent first grid line segments in the second direction is less than or equal to 2 mm.

In some embodiments, the first conductive connector has a hollow structure.

In some embodiments, the first conductive connector has a non-continuous structure, the first conductive connector includes a plurality of first conductive connecting segments disposed at intervals, each first conductive connecting segment completely covers at least one first grid line segment, and an area of each first conductive connecting segment is greater than an area of the first grid line segment covered by the first conductive connecting segment.

In some embodiments, each first conductive connecting segment covers one first grid line segment, and an area of the first conductive connecting segment is greater than twice an area of the first grid line segment covered by the first conductive connecting segment.

In some embodiments, the plurality of first grid line segments are arranged at intervals along the second direction in a single row; or
the plurality of first grid line segments are arranged in a plurality of rows along the first direction, and each row includes at least one first grid line segment.

In some embodiments, when the plurality of first grid line segments are arranged in a plurality of rows along the first direction, a pattern formed by the plurality of first grid line segments is rectangular, trapezoidal, circular, or elliptical.

In some embodiments, in the first interconnection region, a first insulating member is disposed on the second conductive grid line.

In some embodiments, the back-contact cell satisfies at least one of the following: in all the first discontinuous structures in the same first interconnection region, along a direction from edges of the silicon substrate toward a middle position of the silicon substrate, a length of the first discontinuous structure in the second direction gradually decreases, and the edges of the silicon substrate are two opposite edges of the silicon substrate in the first direction; or in all the first conductive connectors in the same first interconnection region, along a direction from edges of the silicon substrate toward a middle position of the silicon substrate, a length of the first conductive connector in the second direction gradually decreases.

In some embodiments, in the same first interconnection region, centers of all the first conductive connectors are located on a straight line in the first direction; or in the same first interconnection region, a line connecting the centers of all the first conductive connectors is a polyline or a wavy line.

In some embodiments, the first grid line segment is dot-shaped or line-shaped.

In some embodiments, in all the first grid line segments of the first discontinuous structure, along a direction from two ends of the first discontinuous structure toward a middle position of the first discontinuous structure, an area of the first grid line segment gradually decreases, and two ends of the first discontinuous structure are two end portions of the first discontinuous structure in the second direction.

In some embodiments, in the second interconnection region, in the second interconnection region, at least a portion of the second conductive grid line is provided with a second discontinuous structure, and the second discontinuous structure includes a plurality of second grid line segments disposed at intervals;
the back-contact cell further includes a plurality of second conductive connectors, the second conductive connector covers the second discontinuous structure and is electrically connected to the second grid line segment, the second conductive connector is insulated from the first conductive grid line, and the second conductive connector is configured to solder with the soldering members arranged in the second interconnection region.

In some embodiments, the second conductive connector is further partially electrically connected to portions of the second conductive grid line located on two sides of the second discontinuous structure.

In some embodiments, the second conductive connector satisfies at least one of the following: a glass content in the second conductive connector is greater than a glass content in the second conductive grid line; or a material of the second conductive connector is different from a material of the second conductive grid line, and a silver content in the second conductive connector is less than a silver content in the second conductive grid line.

In some embodiments, the second conductive connector is partially embedded between two adjacent second grid line segments.

In some embodiments, in the second direction, an overall length of the second discontinuous structure is 0.05 mm to 5 mm.

In some embodiments, a length of a single second grid line segment in the second direction is greater than 0.02 mm.

In some embodiments, in the second discontinuous structure, a spacing between two adjacent second grid line segments in the second direction is less than 2 mm.

In some embodiments, the second conductive connector has a hollow structure.

In some embodiments, the second conductive connector has a non-continuous structure, the second conductive connector includes a plurality of second conductive connecting segments, each second conductive connecting segment completely covers at least one second grid line segment, and an area of each second conductive connecting segment is greater than an area of the second grid line segment covered by the second conductive connecting segment.

In some embodiments, each second conductive connecting segment covers one second grid line segment, and an area of the second conductive connecting segment is greater than twice an area of the second grid line segment covered by the second conductive connecting segment.

In some embodiments, the plurality of second grid line segments are arranged at intervals along the second direction in a single row; or
the plurality of second grid line segments are arranged in a plurality of rows along the first direction, and each row includes at least one second grid line segment.

In some embodiments, when the plurality of second grid line segments are arranged in a plurality of rows along the first direction, a pattern formed by the plurality of second grid line segments is rectangular, trapezoidal, circular, or elliptical.

In some embodiments, in the second interconnection region, a second insulating member is disposed on the first conductive grid line.

In some embodiments, the back-contact cell satisfies at least one of the following: in all the second discontinuous structures in the same second interconnection region, along a direction from edges of the silicon substrate toward a middle position of the silicon substrate, a length of the second discontinuous structure in the second direction gradually decreases, and the edges of the silicon substrate are two opposite edges of the silicon substrate in the first direction; or in all the second conductive connectors in the same second interconnection region, along a direction from edges of the silicon substrate toward a middle position of the silicon substrate, a length of the second conductive connector in the second direction gradually decreases.

In some embodiments, in the same second interconnection region, centers of all the second conductive connectors are located on a straight line in the first direction; or in the same second interconnection region, a line connecting the centers of all the second conductive connectors is a polyline or a wavy line.

In some embodiments, the second grid line segment is dot-shaped or line-shaped.

In some embodiments, in all the second grid line segments of the second discontinuous structure, in the second direction, along a direction from two ends of the second discontinuous structure toward a middle position of the second discontinuous structure, an area of the second grid line segment gradually decreases.

In some embodiments, the doped layers closest to the two edges of the silicon substrate in the first direction are the first doped layers, and the first doped layer has a doping type opposite to that of the silicon substrate.

The present application further provides a cell assembly, where the cell assembly includes a plurality of the cell strings described in any one of the foregoing aspects.

The present application further provides a photovoltaic system, where the photovoltaic system includes the cell assembly described above.

In the back-contact cell, the cell assembly, and the photovoltaic system according to an embodiment of the present application, in the first interconnection region, the first conductive grid line is provided with a first discontinuous structure, and the first discontinuous structure includes a plurality of first grid line segments disposed at intervals along the second direction. The first conductive connector covers the first discontinuous structure and is electrically connected to the first grid line segment. In this way, by configuring the first conductive grid line in the first interconnection region as a discontinuous structure and then covering the first discontinuous structure with the first conductive connector to achieve soldering with the soldering members, compared with the conventional method of thickening and widening the fine grid line at the soldering position, this configuration can ensure soldering performance and reduce usage of paste in the preparation of the first conductive grid line, thereby lowering cost.

A part of the additional aspects and advantages of the present application will be provided in the following, and some will become apparent or can be learned through the practice of the present application.

### Brief Description of Drawings

FIG. 1 is a schematic diagram of modules of a photovoltaic system according to an embodiment of the present application;
FIG. 2 is a schematic diagram of modules of a cell assembly according to an embodiment of the present application;
FIG. 3 is a schematic diagram of a planar structure of a back side of a back-contact cell according to an embodiment of the present application;
FIG. 4 is a schematic cross-sectional diagram of a back-contact cell shown in FIG. 3 along line IV-IV;
FIG. 5 is an enlarged schematic diagram of a back-contact cell shown in FIG. 3 at position V;
FIG. 6 is a schematic diagram of a first conductive grid line of a back-contact cell according to an embodiment of the present application;
FIG. 7 is a schematic cross-sectional diagram of a back-contact cell shown in FIG. 3 along line VII-VII;
FIG. 8 is an enlarged schematic diagram of a back-contact cell shown in FIG. 3 at position VIII;
FIG. 9 is a schematic diagram of a second conductive grid line of a back-contact cell according to an embodiment of the present application;
FIG. 10 is a schematic cross-sectional diagram of a back-contact cell shown in FIG. 3 along line X-X;
FIG. 11 is an enlarged schematic diagram of a back-contact cell shown in FIG. 3 along line XI-XI;
FIG. 12 is a schematic diagram illustrating an arrangement structure of a first discontinuous structure, a second discontinuous structure, a first conductive connector, and a second conductive connector according to an embodiment of the present application;
FIG. 13 is another schematic diagram illustrating an arrangement of a first conductive connector and a second conductive connector according to an embodiment of the present application; and
FIG. 14 is a schematic diagram of structures of a first conductive grid line and a second conductive grid line according to an embodiment of the present application.

Description of main reference numerals:
1000. photovoltaic system; 200. cell assembly; 100. back-contact cell; 10. silicon substrate; 11. back side; 12. front side; 20. first doped layer; 30. second doped layer; 40. first conductive grid line; 41. first discontinuous structure; 411. first grid line segment; 50. second conductive grid line; 51. second discontinuous structure; 511. second grid line segment; 60. first conductive connector; 70. first insulating member; 80. second conductive connector; 90. second insulating member; and 110. rear passivation layer.

### Detailed Description of Embodiments

To make the object, technical solutions, and advantages of the present application clearer, the present application will be further described in detail with reference to the accompanying drawings and embodiments. Embodiments described below with reference to the accompanying drawings are exemplary, and are only intended to explain the present application and cannot be understood as limiting the present application. In addition, it should be understood that the specific embodiments described here are intended for illustrating rather than limiting the present application.

In the description of the present application, it should be understood that, the terms "length", "width", "up", "down", "top", "bottom", "horizontal", and "vertical" indicate the orientation or position relationship based on the orientation or position relationship shown in the attached drawings, only for the convenience of simple description of the present application, rather than indicating or implying that the devices or elements referred to must have a specific orientation, be constructed and operated in a specific orientation, and therefore cannot be understood as a limitation on the present application.

In addition, the terms "first" and "second" are used solely for descriptive purposes and cannot be understood as indicating or implying relative importance or as implicitly specifying the quantity of the indicated technical features. Therefore, the features defined with "first" and "second" may explicitly or implicitly include at least one or a plurality of features. In the description of the present application, the term "a plurality of" means two or more, unless otherwise specifically and explicitly defined.

In the description of the present application, it should be noted that unless otherwise specified and limited, the terms "installation", "connected", and "connection" should be broadly understood, for example, may be fixed connection, detachable connection, or integrated connection, and may be mechanical connection, also be electrical connection, or mutual communication, direct connection or indirect connection through an intermediate medium, and may also be the internal connection or interaction relationship between two components. For those of ordinary skill in the art, the specific meanings of the above terms in the present application can be understood according to the specific circumstances.

In the present application, unless otherwise expressly specified and defined, a first feature being "above" or "below" a second feature may include the first feature and the second feature being in direct contact, or may include the first feature and the second feature not being in direct contact but being in contact through another feature disposed therebetween. Moreover, the first feature being "over", "above" and "on" the second feature includes the first feature being directly above and diagonally above the second feature, or simply indicates that the first feature is horizontally higher than the second feature. The first feature being "below", "beneath", and "under" the second feature includes the first feature being directly below and diagonally below the second feature, or simply indicates that the horizontal height of the first feature is less than that of the second feature.

The following disclosure provides a plurality of different embodiments or examples for implementing various structures of the present application. For the purpose of simplifying the disclosure of the present application, components and arrangements of specific examples are described below. Of course, these examples are provided merely for illustration and are not intended to limit the present application. In addition, the present application may repeat reference numerals and/or letters in the various examples. This repetition is for the purpose of simplicity and clarity and does not in itself dictate a relationship between the various embodiments and/or configurations discussed. In addition, the present application provides examples of various specific processes and materials, but those of ordinary skill in the art can be aware of the present application of other processes and/or the usage scenarios of other materials.

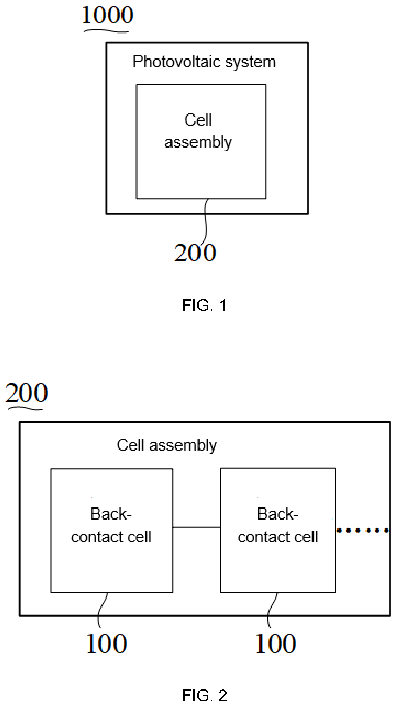

Referring to FIG. 1 and FIG. 2, a photovoltaic system 1000 in an embodiment of the present application may include a cell assembly 200 in an embodiment of the present application, where the cell assembly 200 may include a plurality of back-contact cells 100 in an embodiment of the present application. In the cell assembly 200, each back-contact cell 100 may be connected in series through soldering members (such as solder ribbons) to form a plurality of cell strings, and the cell strings in the cell assembly 200 may be connected in series, in parallel, or in a series-parallel combination to achieve current collection output, for example, by connecting the cell strings through busbars.

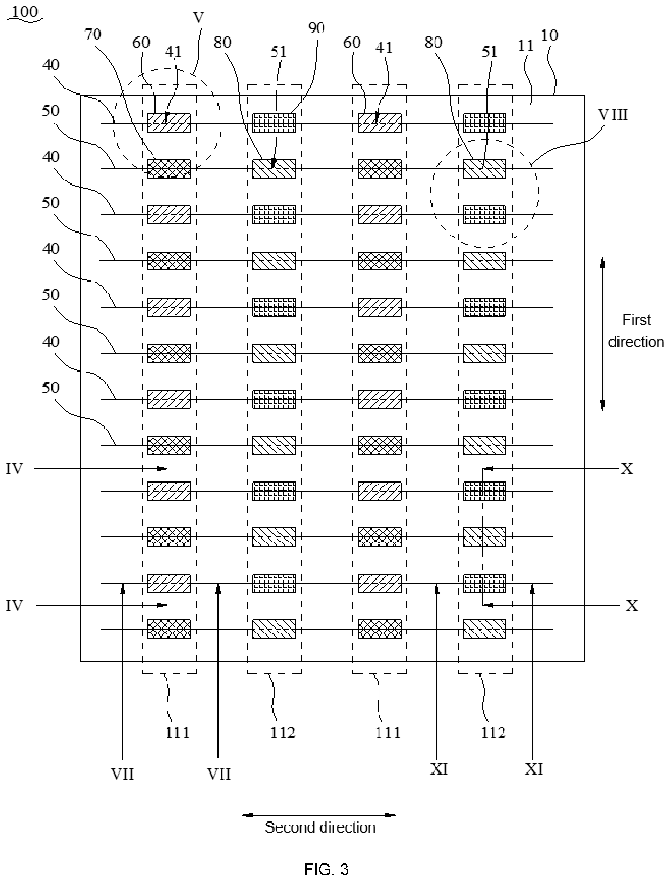

Referring to FIG. 3 to FIG. 6, the back-contact cell 100 in an embodiment of the present application may include a silicon substrate 10, a plurality of first doped layers 20, a plurality of second doped layers 30, a plurality of first conductive grid lines 40, a plurality of second conductive grid lines 50, and a plurality of first conductive connectors 60.

The silicon substrate 10 is provided with a front side 12 and a back side 11 opposite to each other, and the back side 11 is provided with a plurality of first interconnection regions 111 and a plurality of second interconnection regions 112 for arranging soldering members.

It should be noted that the first interconnection region 111 and the second interconnection region 112 are regions covered by soldering members (such as solder ribbons) during soldering. Exemplarily, in some examples, the first interconnection region 111 may be a region covered by positive solder ribbons, and the second interconnection region 112 may be a region covered by negative solder ribbons; in other examples, the first interconnection region 111 may be a region covered by negative solder ribbons, and the second interconnection region 112 may be a region covered by positive solder ribbons.

The first doped layer 20 and the second doped layer 30 are disposed on the back side 11 of the silicon substrate, the first doped layer 20 and the second doped layer 30 have opposite polarities, the plurality of first doped layers 20 and the plurality of second doped layers 30 are alternately arranged along a first direction and extend along a second direction, and the second direction intersects the first direction.

The first conductive grid line 40 is disposed on the first doped layer 20, the second conductive grid line 50 is disposed on the second doped layer 30, the first conductive grid line 40 is electrically connected to the first doped layer 20, the second conductive grid line 50 is electrically connected to the second doped layer 30, the first conductive grid line 40 and the second conductive grid line 50 both extend along the second direction, and the first interconnection region 111 and the second interconnection region 112 intersect the first conductive grid line 40 and the second conductive grid line 50.

Specifically, as shown in FIG. 3, the first direction and the second direction may be the longitudinal direction and the transverse direction of the back-contact cell 100, respectively, and the first direction and the second direction are perpendicular to each other. Of course, in other embodiments, the first direction and the second direction may be other directions, for example, the first direction and the second direction may be the diagonal directions of the silicon substrate 10. This is not specifically limited herein. It is readily understood that, in the back-contact cell 100, the first interconnection regions 111 and the second interconnection regions 112 are alternately arranged along the second direction.

Referring to FIG. 3 and FIG. 5 to FIG. 7, in an embodiment of the present application, in the first interconnection region 111, at least a portion of the first conductive grid line 40 is provided with a first discontinuous structure 41, and the first discontinuous structure 41 includes a plurality of first grid line segments 411 disposed at intervals along the second direction. The first conductive connector 60 covers the first discontinuous structure 41 and is electrically connected to the first grid line segment 411, the first conductive connector 60 is insulated from the second conductive grid line 50, and the first conductive connector 60 is configured to solder with soldering members arranged in the first interconnection region 111.

In the back-contact cell 100, the cell assembly 200, and the photovoltaic system 1000 according to an embodiment of the present application, in the first interconnection region 111, the first conductive grid line 40 is provided with a first discontinuous structure 41, and the first discontinuous structure 41 includes a plurality of first grid line segments 411 disposed at intervals along the second direction. The first conductive connector 60 covers the first discontinuous structure 41 and is electrically connected to the first grid line segment 411. In this way, by configuring the first conductive grid line 40 in the first interconnection region 111 as a discontinuous structure and then covering the first discontinuous structure 41 with the first conductive connector 60 to achieve soldering with the soldering members, compared with the conventional method of thickening and widening the fine grid line at the soldering position, this configuration can ensure soldering performance and reduce usage of paste in the preparation of the first conductive grid line 40, thereby lowering cost.

Specifically, in an embodiment of the present application, all first conductive grid lines 40 can have the first discontinuous structure 41 in the first interconnection region 111. In this case, the back-contact cell 100 may be a busbar-free back-contact cell. Of course, in some embodiments, not all first conductive grid lines 40 may have the first discontinuous structure 41. In this case, a busbar segment connected to the first conductive grid line 40 may be provided between two adjacent first conductive connectors 60. This is not specifically limited herein.

In the present application, the first doped layer 20 and the second doped layer 30 have opposite polarities, where one is a P-type doped layer, and the other is an N-type doped layer; and the first conductive grid line 40 and the second conductive grid line 50 are configured for current collection and have opposite polarities. Meanwhile, the soldering member arranged in the first interconnection region 111 has an opposite polarity to the soldering member arranged in the second interconnection region 112, where one is a positive soldering member, and the other is a negative soldering member.

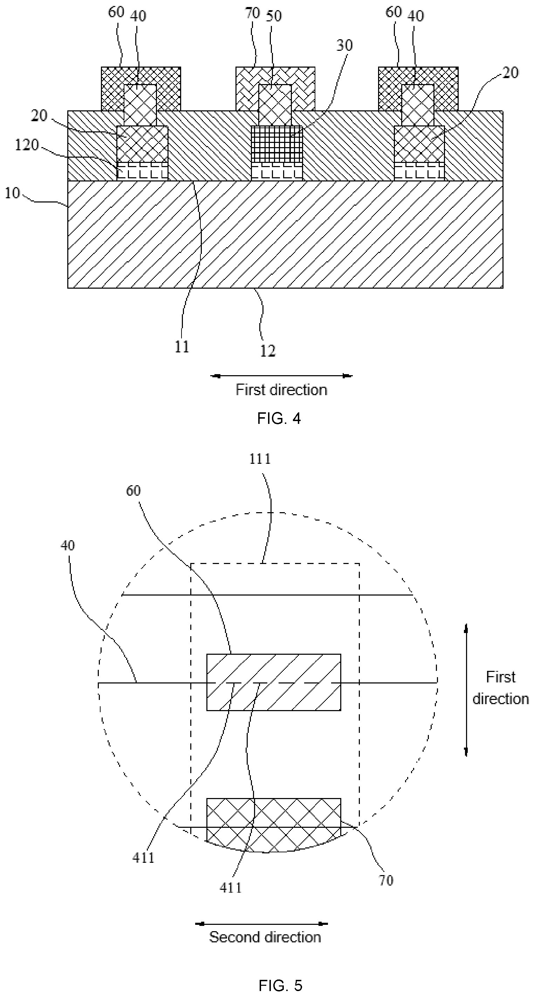

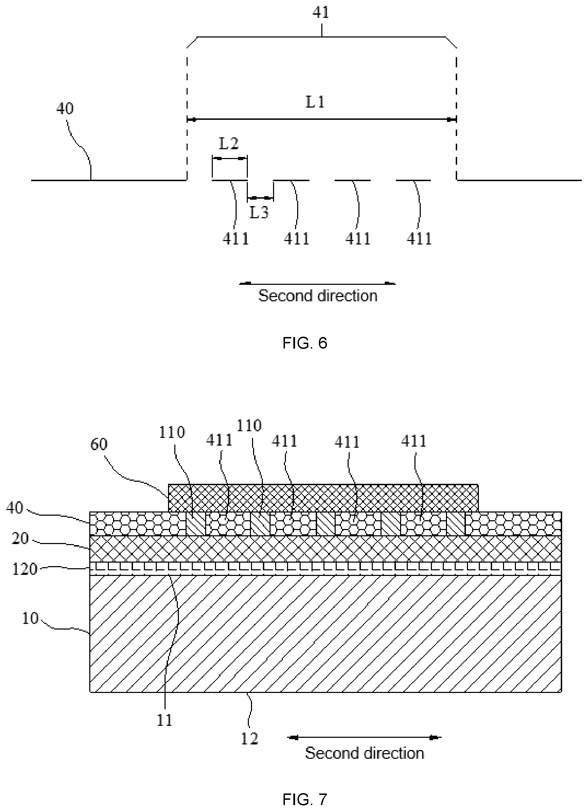

It is readily understood that, as shown in FIG. 4 and FIG. 7, the back side 11 of the silicon substrate 10 in the back-contact cell 100 may be covered with a rear passivation layer 110, and the rear passivation layer 110 at least covers the first doped layer 20 and the second doped layer 30, preferably covering the entire back side 11. As shown in FIG. 7, the first conductive grid line 40 penetrates the rear passivation layer 110 to form an electrical connection with the first doped layer 20, and the second conductive grid line 50 penetrates the rear passivation layer 110 to form an electrical connection with the second doped layer 30.

In some embodiments, the first conductive connectors 60 may not penetrate the rear passivation layer 110 and may be entirely disposed above the rear passivation layer 110 or partially embedded within the rear passivation layer 110.

In some embodiments, the first conductive connectors 60 may be partially embedded between two adjacent first grid line segments 411, and the portion embedded between the first grid line segments 411 may penetrate the rear passivation layer 110 or may not penetrate the rear passivation layer 110. This is not specifically limited herein.

In addition, as shown in FIG. 4 and FIG. 7, in the back-contact cell 100, a tunneling layer 120 is provided between the first doped layers 20, the second doped layers 30, and the silicon substrate 10.

In addition, as shown in FIG. 3, in an embodiment of the present application, each first conductive grid line 40 may be provided with the first discontinuous structure 41 and the first conductive connector 60 at the first interconnection region 111, and the same first conductive grid line 40 may also be provided with the first discontinuous structure 41 and the first conductive connector 60 at different positions of the first interconnection regions 111. That is, along the second direction, each first conductive grid line 40 may be provided with a number of first discontinuous structures 41 corresponding to the number of first interconnection regions 111.

It can be understood that, in the present application, the width of the first conductive connector 60 (i.e., the length in the first direction) may be greater than the width of the first conductive grid line 40 to facilitate soldering with soldering members, and the width of the first conductive connector 60 can reach the width of the widened section of the fine grid line in the conventional technology. Therefore, it is readily understood that, in the conventional technology, the fine grid lines at the soldering positions are thickened and widened, resulting in higher usage of silver paste at those positions. In the present application, during the formation of the first conductive grid line 40, no thickening or widening process is required, a discontinuous structure is formed in the first interconnection region 111, and the first conductive connector 60 is then provided to cover the discontinuous structure for soldering, thereby ensuring soldering performance while reducing the amount of paste used.

In some embodiments, the first conductive connector 60 is further electrically connected to portions of the first conductive grid line 40 located on two sides of the first discontinuous structure 41.

In this way, the first conductive connector 60 directly connects the first discontinuous structure 41 of the first conductive grid line 40 with other portions on two sides of the first discontinuous structure 41 into an integral structure, and during setting of the soldering members, the overall current collection of the first conductive grid line 40 is achieved by soldering the soldering members to the first conductive connector 60.

Specifically, in this embodiment, the length of the first conductive connector 60 in the second direction may be greater than the length of the first discontinuous structure 41, thereby connecting the first discontinuous structure 41 with remaining portions of the first conductive grid line 40.

Of course, it can be understood that, in some embodiments, the first conductive connector 60 may only be electrically connected to the first grid line segment 411 in the first discontinuous structure 41, and current collection of other portions may be achieved by overlapping the soldering members on the portions on two sides of the first discontinuous structure 41 during soldering.

In some embodiments, the doped layers closest to two edges of the silicon substrate 10 in the first direction are the first doped layers 20, and the first doped layer 20 has a doping type opposite to that of the silicon substrate 10.

In this way, the first doped layer 20 serves as an emitter of the back-contact cell 100, and such a design increases the emitter area in the back-contact cell 100, thereby improving efficiency of the back-contact cell 100.

Specifically, in this embodiment, the silicon substrate 10 may be a P-type silicon wafer or an N-type silicon wafer, that is, the doping type of the silicon substrate 10 may be P-type doping or N-type doping. When the doping type of the silicon substrate 10 is P-type doping, the doping type of the first doped layers 20 is N-type doping, and the doping type of the second doped layers 30 is P-type doping.

When the doping type of the silicon substrate 10 is N-type doping, the doping type of the first doped layers 20 is P-type doping, and the doping type of the second doped layers 30 is N-type doping.

That is, regardless of the doping type of the silicon substrate 10, doped layers located at upper and lower edges of the silicon substrate 10 serve as emitters of the back-contact cell 100.

In an embodiment of the present application, the first grid line segment 411 may be dot-shaped or line-shaped. This is not specifically limited herein.

In some embodiments, the first conductive grid line 40 is made of a fire-through paste, and the first conductive connector 60 is made of a non-fire-through paste, that is, the glass content in the first conductive connector 60 is greater than that in the first conductive grid line 40. In this way, during fabrication, the first conductive connector 60 does not completely fire through the rear passivation layer 110, which reduces the amount of paste used.

Specifically, in this embodiment, the first conductive grid line 40 may be a silver grid line, an aluminum grid line, a copper grid line, or a silver-coated copper grid line, and the first conductive connector 60 may be a silver layer, a copper layer, or a silver-coated copper structure. This is not specifically limited herein.

In some embodiments, a material of the first conductive connector 60 differs from a material of the first conductive grid line 40. For example, the first conductive grid line 40 may be a silver grid line, and the first conductive connector 60 may be a silver-coated copper grid line or a copper grid line. In this case, the silver content in the first conductive connector 60 is less than the silver content in the first conductive grid line 40. Thus, the use of silver paste is reduced, thereby lowering cost.

Referring to FIG. 6, in some embodiments, in the second direction, the overall length L1 of the first discontinuous structure 41 is 0.05 mm to 5 mm.

In this way, the overall length of the first discontinuous structure 41 is prevented from being too small, which would increase process difficulty, and the overall length of the first discontinuous structure 41 is also prevented from being too large, which would create excessively unmetalized regions and reduce efficiency.

It should be noted that, as shown in FIG. 6, in the present application, the overall length of the first discontinuous structure 41 refers to the distance between two end points of the first conductive grid line 40 located on two sides of the first discontinuous structure 41, that is, the distance between two end points of the first conductive grid line 40 in the first interconnection region 111 as shown in FIG. 6 (i.e., L1 in the figure).

Specifically, in this embodiment, the overall length of the first discontinuous structure 41 in the second direction may be any value of 0.05 mm, 0.1 mm, 0.2 mm, 0.3 mm, 0.4 mm, 0.5 mm, 0.6 mm, 0.7 mm, 0.8 mm, 0.9 mm, 1 mm, 2 mm, 3 mm, 4 mm, 5 mm, or within the range of 0.05 mm to 5 mm.

In some embodiments, the length L2 of a single first grid line segment 411 in the second direction is greater than 0.02 mm.

In this way, the length of a single first grid line segment 411 is prevented from being too small, which would increase process difficulty, thereby reducing manufacturing cost.

It can be understood that, in this embodiment, regardless of the length of the first grid line segments 411, the total length of all first grid line segments 411 in the first discontinuous structure 41 is less than the overall length of the first discontinuous structure 41.

In some embodiments, in the first discontinuous structure 41, a spacing L3 between two adjacent first grid line segments 411 in the second direction is less than or equal to 2 mm.

In this way, the unmetalized region between two adjacent first grid line segments 411 is prevented from being too small, which would increase control difficulty during processing, and the unmetalized region between two adjacent first grid line segments 411 is also prevented from being too large, which would result in excessive efficiency loss.

Specifically, in this embodiment, the spacing L3 between two adjacent first grid line segments 411 in the second direction may be any value of 0.05 mm, 0.1 mm, 0.2 mm, 0.3 mm, 0.4 mm, 0.5 mm, 0.6 mm, 0.7 mm, 0.8 mm, 0.9 mm, 1 mm, 1.1 mm, 1.2 mm, 1.3 mm, 1.4 mm, 1.5 mm, 1.6 mm, 1.7 mm, 1.8 mm, 1.9 mm, 2 mm, or within the range of 0 mm to 2 mm. This is not specifically limited herein.

Referring to FIG. 6, in some embodiments, the plurality of first grid line segments 411 are arranged at intervals along the second direction in a single row.

Of course, in other embodiments, the plurality of first grid line segments 411 may be arranged in a plurality of rows along the first direction, and each row includes at least one first grid line segment 411, for example, each row may include two or three first grid line segments 411 disposed at intervals along the second direction.

Further, when the plurality of first grid line segments 411 may be arranged in a plurality of rows along the first direction, a pattern formed by the plurality of first grid line segments 411 is rectangular, trapezoidal, circular, or elliptical.

In some embodiments, the first conductive connector 60 may have a hollow structure, that is, the first conductive connector 60 has a hollow region. In this way, the usage amount of silver paste can be further reduced, thereby lowering cost.

In some embodiments, the first conductive connector 60 may be a non-continuous structure. In this case, the first conductive connector 60 may include a plurality of first conductive connecting segments (not shown) disposed at intervals, each first conductive connecting segment completely covers at least one first grid line segment 411, and an area of each first conductive connecting segment is greater than an area of the first grid line segment 411 covered by the first conductive connecting segment.

In this way, by configuring the first conductive connector 60 as a non-continuous structure, the usage amount of silver paste can be reduced, thereby lowering cost.

It should be noted that, in the present application, an area of a structure refers to an orthographic projection area of the structure on the back side 11.

In some embodiments, each first conductive connecting segment may cover one first grid line segment 411, and an area of the first conductive connecting segment is greater than twice an area of the first grid line segment 411 covered by the first conductive connecting segment.

Such an arrangement can ensure the soldering performance between the first conductive connecting segment and the soldering member, thereby preventing the soldering effect from being affected by an insufficient soldering contact area of the entire first conductive connector 50.

Referring to FIG. 3 and FIG. 4, in some embodiments, a first insulating member 70 is provided on the second conductive grid line 50 in the first interconnection region 111.

In this way, during soldering of the soldering member in the first interconnection region 111, the first insulating member 70 may electrically insulate the soldering member in the first interconnection region 111 from the second conductive grid line 50, and each first conductive grid line 40 is electrically connected to the soldering member in the first interconnection region 111, thereby avoiding a short circuit.

Specifically, in an embodiment of the present application, in the first interconnection region 111, the first conductive connector 60 on each first conductive grid line 40 and the first insulating member 70 on each second conductive grid line 50 may be disposed in a row along the second direction. Of course, in some embodiments, the arrangement in one row is not required as long as soldering and insulation can be achieved. This is not specifically limited herein.

Referring to FIG. 3 and FIG. 8 to FIG. 11, in some embodiments, at least a portion of the second conductive grid line 50 is provided with a second discontinuous structure 51 in the second interconnection region 112, and the second discontinuous structure 51 includes a plurality of second grid line segments 511 disposed at intervals; and

the back-contact cell 100 further includes a plurality of second conductive connectors 80, the second conductive connector 80 covers the second discontinuous structure 51 and is electrically connected to the second grid line segment 511, the second conductive connector 80 is insulated from the first conductive grid line 40, and the second conductive connector 80 is configured to solder with the soldering members arranged in the second interconnection region 112.

In this way, by configuring the second conductive grid line 50 in the second interconnection region 112 as a discontinuous structure and then covering the second discontinuous structure 51 with the second conductive connector 80 to achieve soldering with the soldering members, compared with the conventional method of thickening or widening the fine grid line at the soldering position, this configuration can ensure soldering performance and reduce usage of paste in the preparation of the second conductive grid line 50, thereby further lowering cost.

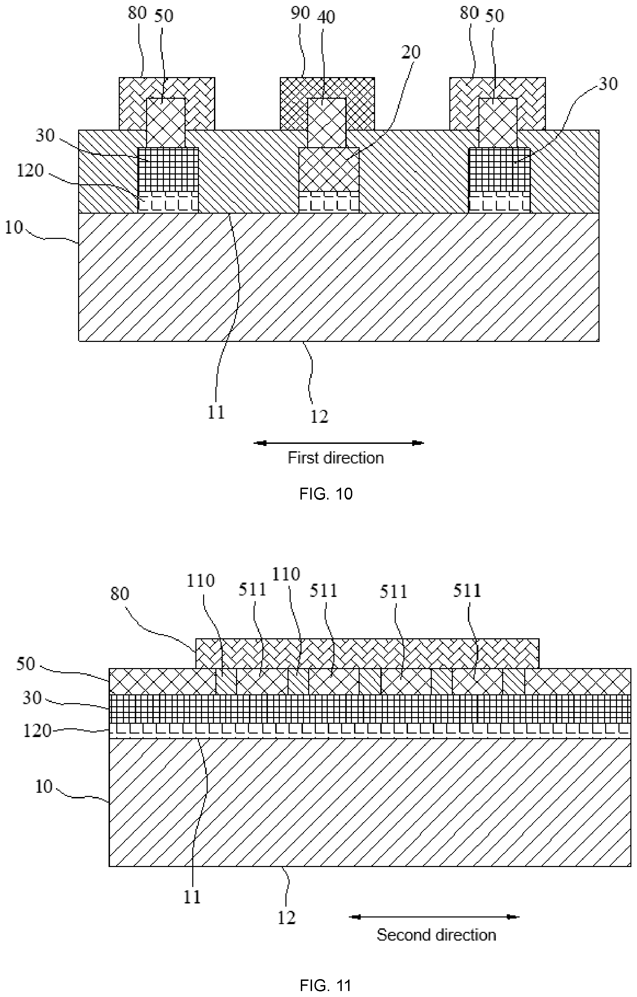

Specifically, in this embodiment, as shown in FIG. 10 and FIG. 11, the second conductive grid line 50 may penetrate the rear passivation layer 110 to form an electrical connection with the second doped layer 30.

In some embodiments, the second conductive connector 80 may not penetrate the rear passivation layer 110 and may be entirely disposed above the rear passivation layer 110 or partially embedded within the rear passivation layer 110.

In some embodiments, the second conductive connector 80 may be partially embedded between two adjacent second grid line segments 511, and the portion embedded between the second grid line segments 511 may penetrate the rear passivation layer 110 or may not penetrate the rear passivation layer 110. This is not specifically limited herein.

In addition, as shown in FIG. 3, in an embodiment of the present application, each second conductive grid line 50 may be provided with the second discontinuous structure 51 and the second conductive connector 80 at the second interconnection region 112, and the same second conductive grid line 50 may also be provided with the second discontinuous structure 51 and the second conductive connector 80 at different positions of the second interconnection regions 112. That is, along the second direction, each second conductive grid line 50 may be provided with a number of second discontinuous structures 51 corresponding to the number of second interconnection regions 112.

Specifically, in an embodiment of the present application, preferably, all second conductive grid lines 50 can have the second discontinuous structure 51 in the second interconnection region 112. In this case, the back-contact cell 100 may be a busbar-free back-contact cell. Of course, in some embodiments, not all second conductive grid lines 50 may have the second discontinuous structure 51. In this case, a busbar segment connected to the second conductive grid line 50 may be provided between two adjacent second conductive connectors 80. This is not specifically limited herein.

In some embodiments, the second conductive connector 80 is further electrically connected to portions of the second conductive grid line 50 located on two sides of the second discontinuous structure 51.

In this way, the first conductive connector 80 directly connects the second discontinuous structure 51 of the second conductive grid line 50 with other portions on two sides of the second discontinuous structure 51 into an integral structure, and during setting of the soldering members, the overall current collection of the second conductive grid line 50 is achieved by soldering the soldering members to the second conductive connector 80.

Specifically, in this embodiment, the length of the second conductive connector 80 in the second direction may be greater than the length of the second discontinuous structure 51, thereby connecting the second discontinuous structure 51 with remaining portions of the second conductive grid line 50.

Of course, it can be understood that, in some embodiments, the second conductive connector 80 may only be electrically connected to the second grid line segment 511 in the second discontinuous structure 51, and current collection of other portions may be achieved by overlapping the soldering members on the portions on two sides of the second discontinuous structure 51 during soldering.

In some embodiments, the second conductive grid line 50 is made of a fire-through paste, and the second conductive connector 80 is made of a non-fire-through paste, that is, the glass content in the second conductive connector 80 is greater than that in the second conductive grid line 50. In this way, during fabrication, the second conductive connector 80 does not fire through the rear passivation layer 110, which reduces the amount of paste used.

Specifically, in this embodiment, the second conductive grid line 50 may be a silver grid line, an aluminum grid line, a copper grid line, or a silver-coated copper grid line, and the second conductive connector 80 may be a silver layer, a copper layer, or a silver-coated copper structure. This is not specifically limited herein.

In some embodiments, a material of the second conductive connector 80 differs from a material of the second conductive grid line 50. For example, the second conductive grid line 50 may be a silver grid line, and the second conductive connector 80 may be a silver-coated copper grid line or a copper grid line. In this case, the silver content in the second conductive connector 80 is less than the silver content in the second conductive grid line 50. Thus, the use of silver paste is reduced, thereby lowering cost.

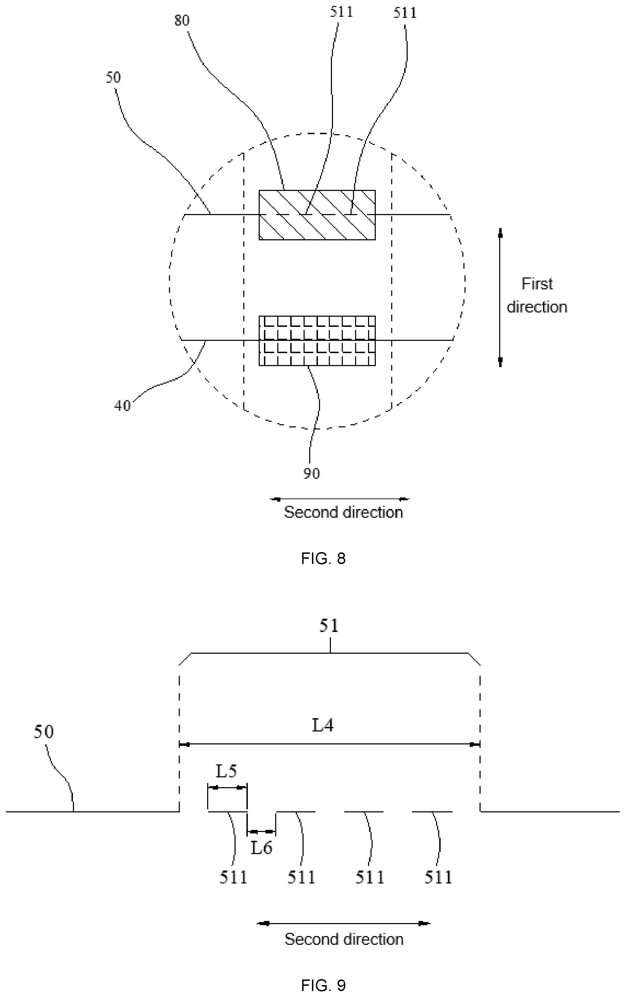

Referring to FIG. 9, in some embodiments, in the second direction, the overall length L4 of the second discontinuous structure 51 is 0.05 mm to 5 mm.

In this way, the overall length of the second discontinuous structure 51 is prevented from being too small, which would increase process difficulty, and the overall length of the second discontinuous structure 51 is also prevented from being too large, which would create excessively unmetalized regions and reduce efficiency.

It should be noted that, in the present application, the overall length of the second discontinuous structure 51 refers to the distance between two end points of the first conductive grid line located on two sides of the second discontinuous structure 51, that is, the distance between two end points of the second conductive grid line 50 in the second interconnection region 112 as shown in FIG. 9 (i.e., L4 in the figure).

Specifically, in this embodiment, the overall length L4 of the second discontinuous structure 51 in the second direction may be any value of 0.05 mm, 0.1 mm, 0.2 mm, 0.3 mm, 0.4 mm, 0.5 mm, 0.6 mm, 0.7 mm, 0.8 mm, 0.9 mm, 1 mm, 2 mm, 3 mm, 4 mm, 5 mm, or within the range of 0.05 mm to 5 mm.

In some embodiments, the length L5 of a single second grid line segment 511 in the second direction is greater than 0.02 mm.

In this way, the length of a single second grid line segment 511 is prevented from being too small, which would increase process difficulty, thereby reducing manufacturing cost.

It can be understood that, in this embodiment, regardless of the length of the second grid line segments 511, the total length of all second grid line segments 511 in the second discontinuous structure 51 is less than the overall length of the second discontinuous structure 51.

In some embodiments, in the second discontinuous structure 51, a spacing L6 between two adjacent second grid line segments 511 in the second direction is less than or equal to 2 mm.

In this way, the unmetalized region between two adjacent second grid line segments 511 is prevented from being too small, which would increase control difficulty during processing, and the unmetalized region between two adjacent second grid line segments 511 is also prevented from being too large, which would result in excessive efficiency loss.

Specifically, in this embodiment, the spacing L6 between two adjacent second grid line segments 511 in the second direction may be any value of 0.05 mm, 0.1 mm, 0.2 mm, 0.3 mm, 0.4 mm, 0.5 mm, 0.6 mm, 0.7 mm, 0.8 mm, 0.9 mm, 1 mm, 1.1 mm, 1.2 mm, 1.3 mm, 1.4 mm, 1.5 mm, 1.6 mm, 1.7 mm, 1.8 mm, 1.9 mm, 2 mm, or within the range of 0 mm to 2 mm. This is not specifically limited herein.

Referring to FIG. 9, in some embodiments, the plurality of second grid line segments 511 are arranged at intervals along the second direction in a single row.

Of course, in other embodiments, the plurality of second grid line segments 511 may be arranged in a plurality of rows along the first direction, and each row includes at least one second grid line segment 511, for example, each row may include two or three second grid line segments 511 disposed at intervals along the second direction.

Further, when the plurality of second grid line segments 511 may be arranged in a plurality of rows along the first direction, a pattern formed by the plurality of second grid line segments 511 is rectangular, trapezoidal, circular, or elliptical.

In some embodiments, the second conductive connector 80 may have a hollow structure, that is, the second conductive connector 80 has a hollow region. In this way, the usage amount of silver paste can be further reduced, thereby lowering cost.

In some embodiments, the second conductive connector 80 may be a non-continuous structure. In this case, the second conductive connector 80 includes a plurality of second conductive connecting segments (not shown) disposed at intervals, each second conductive connecting segment completely covers at least one second grid line segment 511, and an area of each second conductive connecting segment is greater than an area of the second grid line segment 511 covered by the second conductive connecting segment.

In this way, by configuring the second conductive connector 80 as a non-continuous structure, the usage amount of silver paste can be reduced, thereby lowering cost.

It should be noted that, in the present application, an area of a structure refers to an orthographic projection area of the structure on the back side 11.

In some embodiments, each second conductive connecting segment covers one second grid line segment 511, and an area of the second conductive connecting segment is greater than twice an area of the second grid line segment 511 covered by the second conductive connecting segment.

Such an arrangement can ensure the soldering performance between the second conductive connecting segment and the soldering member, thereby preventing the soldering effect from being affected by an insufficient soldering contact area of the entire second conductive connector 80.

Referring to FIG. 3 and FIG. 10, in some embodiments, a second insulating member 90 is provided on the second conductive grid line 50 in the second interconnection region 112.

In this way, during soldering of the soldering member in the second interconnection region 112, the second insulating member 90 may electrically insulate the soldering member in the second interconnection region 112 from the second conductive grid line 50, and each second conductive grid line 50 is electrically connected to the soldering member in the second interconnection region 112, thereby avoiding a short circuit.

Specifically, in an embodiment of the present application, in the second interconnection region 112, the second conductive connector 80 on each second conductive grid line 50 and the second insulating member 90 on each second conductive grid line 50 may be disposed in a row along the second direction. Of course, in some embodiments, the arrangement in one row is not required as long as soldering and insulation can be achieved. This is not specifically limited herein.

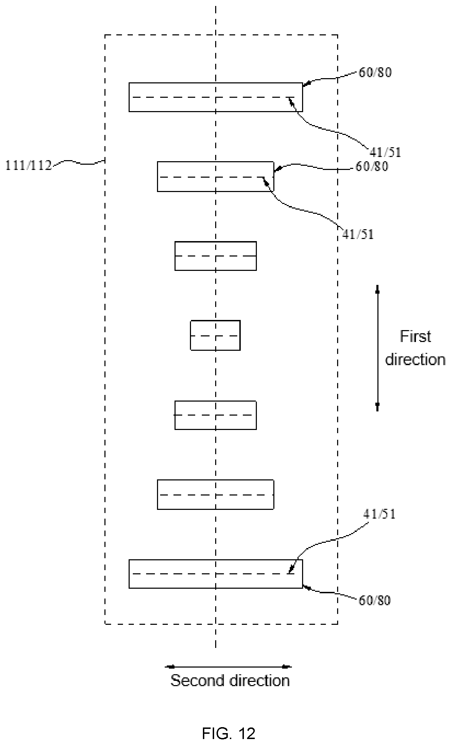

Referring to FIG. 12, in some embodiments, in all first discontinuous structures 41 within the same first interconnection region 111, along the first direction, the length of the first discontinuous structure 41 in the second direction gradually decreases from the edges of the silicon substrate 10 (i.e., the upper and lower edges shown in FIG. 1) toward the middle position of the silicon substrate 10.

In this way, the soldering stability of the starting and ending points during soldering can be ensured, and the metallized area in the middle region is increased, thereby improving efficiency.

In addition, still referring to FIG. 12, in some embodiments, in all first conductive connectors 60 within the same first interconnection region 111, along the first direction, the length of the first conductive connector 60 in the second direction gradually decreases from the edges of the silicon substrate 10 toward the middle position of the silicon substrate 10.

In this way, the soldering stability of the starting and ending points during soldering can be ensured, and the length of the first conductive connector 60 in the middle region is reduced, thereby further reducing the usage of paste.

Similarly, in some embodiments, in all second discontinuous structures 51 within the same second interconnection region 112, along the first direction, the length of the second discontinuous structure 51 in the second direction gradually decreases from the edges of the silicon substrate 10 (i.e., the upper and lower edges shown in FIG. 1) toward the middle position of the silicon substrate 10.

In this way, the soldering stability of the starting and ending points during soldering can be ensured, and the metallized area in the middle region is increased, thereby improving efficiency.

In addition, in some embodiments, in all second conductive connectors 80 within the same first interconnection region 112, along the first direction, the length of the second conductive connector 80 in the second direction gradually decreases from the edges of the silicon substrate 10 toward the middle position of the silicon substrate 10.

In this way, the soldering stability of the starting and ending points during soldering can be ensured, and the length of the second conductive connector 80 in the middle region is reduced, thereby further reducing the usage of paste.

Still referring to FIG. 12, in some embodiments, in the same first interconnection region 111, centers of all first conductive connectors 60 are located on the same straight line along the first direction. In this way, the soldering precision of the soldering member can be improved.

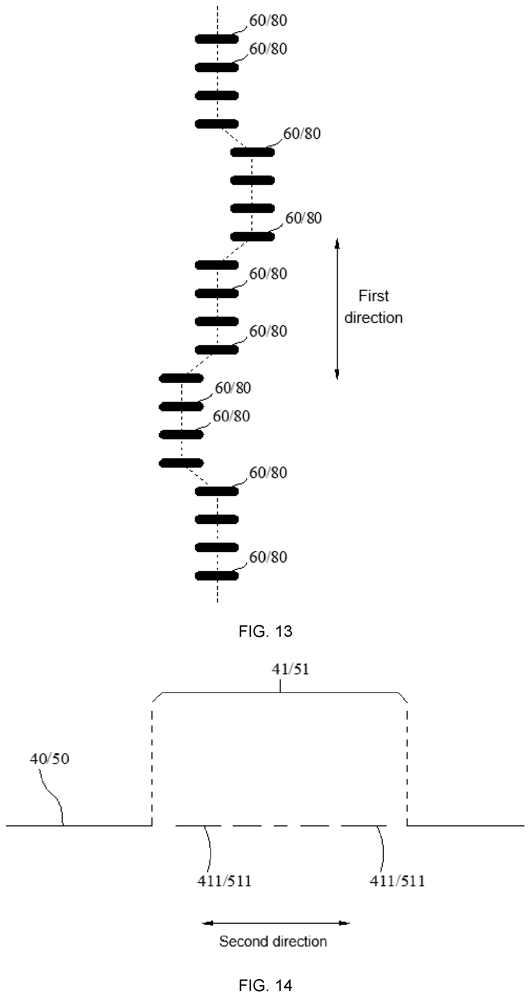

Of course, referring to FIG. 13, in some embodiments, the line formed by the centers of all first conductive connectors 60 within the same first interconnection region 111 may be a polyline or a wavy line.

In this way, when pre-adhesive is applied to pre-fix the soldering members, the pre-adhesive can be arranged at the bending positions of the polyline or wavy line, such that the distance between the pre-adhesive and the first conductive connector at the bending position is relatively large, thereby effectively avoiding poor soldering during subsequent soldering.

Similarly, in some embodiments, in the same second interconnection region 112, the line formed by the centers of all second conductive connectors 80 may be a polyline or a wavy line.

In this way, when pre-adhesive is applied to pre-fix the soldering members, the pre-adhesive can be arranged at the bending positions of the polyline or wavy line, such that the distance between the pre-adhesive and the first conductive connector at the bending position is relatively large, thereby effectively avoiding poor soldering during subsequent soldering.

Referring to FIG. 14, in some embodiments, in all first grid line segments 411 of the first discontinuous structure 41, along the second direction, the area of the first grid line segment 411 gradually decreases from two ends of the first discontinuous structure 41 toward the middle position of the first discontinuous structure 41.

In this way, by setting larger areas for the first grid line segments 411 at two ends of the first discontinuous structure 41, the soldering tensile strength can be ensured, and the usage of paste is further reduced.

Specifically, in this embodiment, to achieve different area sizes, the length of the first grid line segment 411 (i.e., the length in the second direction) can be changed when the width of the first grid line segment 411 (i.e., the length in the first direction) is determined, or the width of the first grid line segment 411 (i.e., the length in the first direction) can be changed when the length of the first grid line segment 411 (i.e., the length in the second direction) is determined. This is not specifically limited herein.

Similarly, still referring to FIG. 14, in some embodiments, in all second grid line segments 511 of the second discontinuous structure 51, along the second direction, the area of the second grid line segment 511 gradually decreases from two ends of the second discontinuous structure 51 toward the middle position of the second discontinuous structure 51.

In this way, by setting larger areas for the second grid line segments 511 at two ends of the second discontinuous structure 51, the soldering tensile strength can be ensured, and the usage of paste is further reduced.

Specifically, in this embodiment, to achieve different area sizes, the length of the second grid line segment 511 (i.e., the length in the second direction) can be changed when the width of the second grid line segment 511 (i.e., the length in the first direction) is determined, or the width of the second grid line segment 511 (i.e., the length in the first direction) can be changed when the length of the second grid line segment 511 (i.e., the length in the second direction) is determined. This is not specifically limited herein.

In the description of the specification, the reference terms "an embodiment", "some embodiments", "examples", "specific examples", or "some examples" refer to the specific features, structures, materials, or characteristics described in conjunction with embodiments or examples included in at least one embodiment or example of the present application. In this specification, the illustrative descriptions of the above terms do not necessarily refer to the same embodiment or example. Moreover, the specific features, structures, materials, or characteristics described can be combined in a suitable manner in any one or more embodiments or examples.

Although embodiments of the present application have been illustrated and described, it can be understood by those of ordinary skill in the art that variations, modifications, substitutions, and alterations can be made to these embodiments without departing from the principles and spirit of the present application. The scope of the present application is defined by the claims and equivalents thereof.

## Claims

1. A back-contact cell, comprising:
a silicon substrate, wherein the silicon substrate is provided with a back side and a front side opposite to each other, and the back side is provided with a plurality of first interconnection regions and a plurality of second interconnection regions for arranging soldering members;
a plurality of first doped layers and a plurality of second doped layers disposed on the back side, wherein the first doped layer and the second doped layer have opposite polarities, the plurality of first doped layers and the plurality of second doped layers are alternately arranged along a first direction and extend along a second direction, and the second direction intersects the first direction;
a first conductive grid line disposed on the first doped layer and a second conductive grid line disposed on the second doped layer, wherein the first conductive grid line is electrically connected to the first doped layer, the second conductive grid line is electrically connected to the second doped layer, the first conductive grid line and the second conductive grid line both extend along the second direction, the first interconnection region intersects each of the first conductive grid line and the second conductive grid line, the second interconnection region intersects each of the first conductive grid line and the second conductive grid line, at least a portion of the first conductive grid line in the first interconnection region is provided with a first discontinuous structure, and the first discontinuous structure comprises a plurality of first grid line segments disposed at intervals; and
a plurality of first conductive connectors, wherein the first conductive connector covers the first discontinuous structure and is electrically connected to the first grid line segment, the first conductive connector is insulated from the second conductive grid line, and the first conductive connector is configured to solder with the soldering members arranged in the first interconnection region.

2. The back-contact cell according to claim 1, wherein the first conductive connector is further partially electrically connected to portions of the first conductive grid line located on two sides of the first discontinuous structure.

3. The back-contact cell according to claim 1, wherein the first conductive connector satisfies at least one of the following:
a glass content in the first conductive connector is greater than a glass content in the first conductive grid line; or
a material of the first conductive connector is different from a material of the first conductive grid line, and a silver content in the first conductive connector is less than a silver content in the first conductive grid line.

4. The back-contact cell according to claim 1, wherein the first conductive connector is partially embedded between two adjacent first grid line segments.

5. The back-contact cell according to claim 1, wherein in the second direction, an overall length of the first discontinuous structure is 0.05 mm to 5 mm.

6. The back-contact cell according to claim 1, wherein a length of a single first grid line segment in the second direction is greater than 0.02 mm.

7. The back-contact cell according to claim 1, wherein in the first discontinuous structure, a spacing between two adjacent first grid line segments in the second direction is less than or equal to 2 mm.

8. The back-contact cell according to claim 1, wherein the first conductive connector has a hollow structure.

9. The back-contact cell according to claim 1, wherein the first conductive connector has a non-continuous structure, the first conductive connector comprises a plurality of first conductive connecting segments disposed at intervals, each first conductive connecting segment completely covers at least one first grid line segment, and an area of each first conductive connecting segment is greater than an area of the first grid line segment covered by the first conductive connecting segment.

10. The back-contact cell according to claim 9, wherein each first conductive connecting segment covers one first grid line segment, and an area of the first conductive connecting segment is greater than twice an area of the first grid line segment covered by the first conductive connecting segment.

11. The back-contact cell according to claim 1, wherein the plurality of first grid line segments are arranged at intervals along the second direction in a single row; or
the plurality of first grid line segments are arranged in a plurality of rows along the first direction, and each row comprises at least one first grid line segment.

12. The back-contact cell according to claim 11, wherein when the plurality of first grid line segments are arranged in a plurality of rows along the first direction, a pattern formed by the plurality of first grid line segments is rectangular, trapezoidal, circular, or elliptical.

13. The back-contact cell according to claim 1, wherein in the first interconnection region, a first insulating member is disposed on the second conductive grid line.

14. The back-contact cell according to claim 1, wherein the back-contact cell satisfies at least one of the following:
in all the first discontinuous structures in the same first interconnection region, along a direction from edges of the silicon substrate toward a middle position of the silicon substrate, a length of the first discontinuous structure in the second direction gradually decreases, and the edges of the silicon substrate are two opposite edges of the silicon substrate in the first direction; or
in all the first conductive connectors in the same first interconnection region, along a direction from edges of the silicon substrate toward a middle position of the silicon substrate, a length of the first conductive connector in the second direction gradually decreases.

15. The back-contact cell according to claim 1, wherein in the same first interconnection region, centers of all the first conductive connectors are located on a straight line in the first direction; or in the same first interconnection region, a line connecting the centers of all the first conductive connectors is a polyline or a wavy line.

16. The back-contact cell according to claim 1, wherein the first grid line segment is dot-shaped or line-shaped.

17. The back-contact cell according to claim 1, wherein in all the first grid line segments of the first discontinuous structure, along a direction from two ends of the first discontinuous structure toward a middle position of the first discontinuous structure, an area of the first grid line segment gradually decreases, and two ends of the first discontinuous structure are two end portions of the first discontinuous structure in the second direction.

18. The back-contact cell according to claim 1, wherein in the second interconnection region, at least a portion of the second conductive grid line is provided with a second discontinuous structure, and the second discontinuous structure comprises a plurality of second grid line segments disposed at intervals; and
the back-contact cell further comprises a plurality of second conductive connectors, the second conductive connector covers the second discontinuous structure and is electrically connected to the second grid line segment, the second conductive connector is insulated from the first conductive grid line, and the second conductive connector is configured to solder with the soldering members arranged in the second interconnection region.

19. The back-contact cell according to claim 18, wherein the second conductive connector is further partially electrically connected to portions of the second conductive grid line located on two sides of the second discontinuous structure.

20. The back-contact cell according to claim 18, wherein the second conductive connector satisfies at least one of the following:
a glass content in the second conductive connector is greater than a glass content in the second conductive grid line; or
a material of the second conductive connector is different from a material of the second conductive grid line, and a silver content in the second conductive connector is less than a silver content in the second conductive grid line.

21. The back-contact cell according to claim 18, wherein the second conductive connector is partially embedded between two adjacent second grid line segments.

22. The back-contact cell according to claim 18, wherein in the second direction, an overall length of the second discontinuous structure is 0.05 mm to 5 mm.

23. The back-contact cell according to claim 18, wherein a length of a single second grid line segment in the second direction is greater than 0.02 mm.

24. The back-contact cell according to claim 18, wherein in the second discontinuous structure, a spacing between two adjacent second grid line segments in the second direction is less than 2 mm.

25. The back-contact cell according to claim 18, wherein the second conductive connector has a hollow structure.

26. The back-contact cell according to claim 18, wherein the second conductive connector has a non-continuous structure, the second conductive connector comprises a plurality of second conductive connecting segments, each second conductive connecting segment completely covers at least one second grid line segment, and an area of each second conductive connecting segment is greater than an area of the second grid line segment covered by the second conductive connecting segment.

27. The back-contact cell according to claim 26, wherein each second conductive connecting segment covers one second grid line segment, and an area of the second conductive connecting segment is greater than twice an area of the second grid line segment covered by the second conductive connecting segment.

28. The back-contact cell according to claim 18, wherein the plurality of second grid line segments are arranged at intervals along the second direction in a single row; or
the plurality of second grid line segments are arranged in a plurality of rows along the first direction, and each row comprises at least one second grid line segment.

29. The back-contact cell according to claim 28, wherein when the plurality of second grid line segments are arranged in a plurality of rows along the first direction, a pattern formed by the plurality of second grid line segments is rectangular, trapezoidal, circular, or elliptical.

30. The back-contact cell according to claim 18, wherein in the second interconnection region, a second insulating member is disposed on the first conductive grid line.

31. The back-contact cell according to claim 18, wherein the back-contact cell satisfies at least one of the following:
in all the second discontinuous structures in the same second interconnection region, along a direction from edges of the silicon substrate toward a middle position of the silicon substrate, a length of the second discontinuous structure in the second direction gradually decreases, and the edges of the silicon substrate are two opposite edges of the silicon substrate in the first direction; or
in all the second conductive connectors in the same second interconnection region, along a direction from edges of the silicon substrate toward a middle position of the silicon substrate, a length of the second conductive connector in the second direction gradually decreases.

32. The back-contact cell according to claim 18, wherein in the same second interconnection region, centers of all the second conductive connectors are located on a straight line in the first direction; or in the same second interconnection region, a line connecting the centers of all the second conductive connectors is a polyline or a wavy line.

33. The back-contact cell according to claim 18, wherein the second grid line segment is dot-shaped or line-shaped.

34. The back-contact cell according to claim 18, wherein in all the second grid line segments of the second discontinuous structure, in the second direction, along a direction from two ends of the second discontinuous structure toward a middle position of the second discontinuous structure, an area of the second grid line segment gradually decreases.

35. The back-contact cell according to any one of claims 1-34, wherein doped layers closest to the two edges of the silicon substrate in the first direction are the first doped layers, and the first doped layer has a doping type opposite to that of the silicon substrate.

36. A cell assembly, comprising a plurality of the back-contact cells according to any one of claims 1-35.

37. A photovoltaic system, comprising the cell assembly according to claim 36.
